# EUROPEAN PATENT SPECIFICATION

(11) **EP 3 203 499 B1**
(45) Date of publication and mention of the grant of the patent: **17.10.2018**
(21) Application number: 17152685.8
(22) Date of filing: 23.01.2017
(51) Int. Cl.: H01L 21/033

(54) **A METHOD OF PATTERNING A TARGET MATERIAL LAYER**
VERFAHREN ZUR STRUKTURIERUNG EINER ZIELMATERIALSCHICHT
PROCÉDÉ DE FORMATION DE MOTIFS SUR UNE COUCHE DE MATÉRIAU CIBLE

(30) Priority: 28.01.2016 EP 16153064
(43) Date of publication of application: 09.08.2017
(73) Proprietor: IMEC vzw, 3001 Leuven (BE)
(72) Inventor: RAGHAVAN, Praveen, 3001 Leuven (BE); BOEMMELS, Juergen, 3001 Leuven (BE)
(74) Representative: AWA Sweden AB

(56) References cited:
- EP-A2- 1 359 613
- WO-A2-2008/059440
- US-A1- 2006 228 895
- US-A1- 2014 193 974
- US-A1- 2015 311 063

## Description

### Technical field

The present inventive concept relates to the field of semiconductor fabrication. In particular, the present inventive concept relates to a method of patterning a target material layer.

### Background

Photolithographic methods may be considered to be a major cornerstone of the semiconductor industry. A photolithographic method may involve defining geometrical features by an optical mask and then transferring the features to a target material layer (on e.g. a wafer) such that the target material layer may be patterned. As integrated circuits continues to become smaller and smaller, and simultaneously containing more and more electronic components within a given area, formation of e.g. circuit or contact patterns using optical masks becomes both more expensive and more difficult. As the separation between neighboring features approaches the wavelength of the light used in a photolithographic method, and thus the critical dimensional unit (CDU), trying to define and transfer a complete pattern using a single optical mask may no longer be a viable option and new techniques are required.

As an alternative to using a single optical mask, one option may be to divide the complete pattern into two or more sub-patterns which are defined by individual sub-masks. As long as each sub-pattern may be defined such that it does not contain any features whose separation is less than the CDU, the complete pattern may be produced by transferring one sub-pattern at a time using the corresponding sub-mask. Such a technique, commonly referred to as e.g. double or triple patterning, will however present the difficulty of aligning each sub-mask relative to the target material layer. If the alignment between two consecutive sub-masks is poor, features defined on separate sub-masks may end up too close or too far from each other. If too close, unwanted connections between features may form, or, if too far, wanted connections may be left out or broken. Poor alignment may also affect the capacitance between neighboring features in a pattern transferred to the target material layer using the features as mask portions, as the capacitance is often depending on the separating distance.

Instead of using multiple sub-masks, other methods may include the formation of mandrels on the target material layer, mandrels that are then used as support for subsequent growth of one or many spacers. If the spacers grow on both sides of a mandrel, the separation between individual spacers may be less than that between individual mandrels. As a result, the pattern formed by the individual spacers may therefore contain features that are separated with less than the CDU. Such methods, examples of which are self-aligned double or quadruple patterning (SADP and SAQP) may remove the problem with sub-mask alignment, but in turn introduce a number of other constraints such as limited flexibility in terms of what features that may be created on the target material layer, and how the target material layer may be patterned.

### Summary of the inventive concept

In view of the above, an objective of the present inventive concept is to provide a method for patterning a target material layer, in which one or many of the above mentioned drawbacks are at least partially resolved or mitigated.

According to an aspect of the present inventive concept there is provided a method for patterning a target material layer. The method comprises:
forming a first feature and a second feature over the target material layer;
forming a first spacer on a sidewall of the first feature facing the second feature, and forming a second spacer on a sidewall of the second feature facing the first feature;
forming a third feature over the target material layer between the first and second features;
removing the first and second spacers;
forming, after removing the first and second spacers, a third spacer on a sidewall of the third feature facing the second feature, and forming a fourth spacer on a sidewall of the second feature facing the third feature;
forming a fourth feature over the target material layer between the second and third features; and
patterning the target material layer using the third and fourth features, and at least one of the first and second features, as mask portions.

The inventive method enables patterning of a target material layer by dividing the pattern into sub-patterns defined by different features, features that may (if belonging to different sub-patterns) be separated with less than the CDU and therefore not suitably formed in one step using e.g. a single mask.

The first and second feature may be formed using a first sub-mask. The first and the second feature may be formed by depositing a feature material layer over the target material layer and subsequently patterning the feature material layer (using the first sub-mask) to form the first and the second feature.

The first and second feature may also be formed using separate sub-masks. Preferably, the first and second features are formed using a same sub-mask, since additional photolithographic steps may then be eliminated and complexity and cost may be reduced.

The third feature may be formed using a second sub-mask. The third feature may be formed by depositing a feature material layer over the target material layer and subsequently patterning the feature material layer (using the second sub-mask) to form the third feature.

The fourth feature may be formed using a third sub-mask. The fourth feature may be formed by depositing a feature material layer over the target material layer and subsequently patterning the feature material layer (using the third sub-mask) to form the fourth feature.

Preferably, both the first and second spacer is formed simultaneously, or during a same process, since the number of spacer growth steps may then be reduced, thus reducing the complexity and cost of the method. Likewise, if e.g. both the first and second features are formed during the same step, allowing for the formation of also the second spacer (and not only the first spacer) during the same process reduces the need for additional steps such as masking of the second feature while forming (e.g. growing) the first spacer.

The first spacer and the second spacer may be formed by depositing a spacer material over the target material layer and the first and second features and etching the deposited spacer material such that the spacer material remains at least on said sidewall of the first feature (to form the first spacer) and on said sidewall of the second feature (to form the second spacer).

During a simultaneous formation of the first and the second spacers, the first and the second spacers as defined here may initially form part of a single larger spacer layer (e.g. just after deposition of a layer of spacer material that covers the features, and before completion of a subsequent etching process of said spacer material layer). As such, the here present labeling of spacers as e.g. "first" and "second" refers to spacer portions that are located at sidewalls on different features, not taking into account that said spacers may once have been part of the same spacer structure.

By forming the first and second spacers before forming the third feature, the risk of the third feature ending up being formed too close to one of the first and second features may be reduced or completely eliminated. Instead of being formed too close to one of the first and second features (e.g. by poor alignment of at least one of a first and second sub-mask), part of the third feature may instead be formed such that it overlaps at least one of the first and second spacers. The overlapping part may then, if necessary, be removed in an additional step, e.g. by chemical mechanical planarization or by another suitable process.

By removing the first and second spacers before the subsequent forming of the third and fourth spacers, the forming of the fourth feature may be easier and the risk of poor alignment reduced, and the patterning of the target material layer using the third and fourth features, and at least one of the first and second features, as mask portions may be improved and more accurate. Due to the presence of the third and fourth spacers, the risk of the fourth feature being formed too close to either one of the second and third feature is eliminated. Poor alignment may instead end up with a part of the fourth feature being formed such that it overlaps at least one of the third and fourth spacers. As mentioned above, such an overlap may, if necessary, be removed in an additional step.

If the second spacer is not removed before the forming of the fourth spacer, the fourth spacer would form not on a sidewall of the second feature but on a sidewall of the second spacer. The combined width of both the second and fourth spacer may be too wide, increasing the risk of poor alignment of the fourth feature, and/or increasing the risk that too big of a part of the fourth feature ends up being formed on top of the fourth (and in some cases also the third) spacer, thus making the remaining part of the fourth feature too narrow or broken. The inventive method resolves this problem by removing the first and second spacers before forming the third and fourth spacers.

By using the second and fourth features, and at least one of the first and second features, as mask portions, the inventive method allows the target material layer to be patterned such that the benefits in terms of e.g. flexibility of using multiple sub-masks are available while, at the same time, the aforementioned problems of alignment of e.g. sub-masks and features belonging to different sub-masks are at least mitigated.

Preferably, also the third and the fourth spacers are formed simultaneously, or during a same process. The third spacer and the fourth spacer may be formed by depositing a spacer material over the target material layer, the second feature and the third feature and etching the deposited spacer material such that the spacer material remains on at least said sidewall of the third feature (to form the third spacer) and said sidewall of the second feature (to form the fourth spacer).

In one embodiment, the inventive method may further comprise removing the third and fourth spacers after forming the fourth feature. By doing so, the subsequent patterning of the target material layer may be easier and more accurate.

In one embodiment, the inventive method may further comprise forming the first and second features using a same sub-mask.

In one embodiment, the third feature may be formed using at least one of the first and second spacers as a guide. If, e.g., the first spacer is used as a guide, the width of the first spacer may guarantee that the third feature is not formed closer to the first feature than said width. Likewise, the width of the second spacer defines a minimal distance that separates the second feature and the third feature. With "guide", it is also envisaged that the third feature may be formed such that at least a part of it overlaps at least one of the first and the second spacer. By allowing the third feature to overlap a spacer, less accuracy is needed when positioning e.g. a sub-mask used during the formation of the third feature. During a later step, the overlap may be removed. Even though the third feature may end up having a reduced width, a minimal distance to e.g. the first or second feature may still be guaranteed and defined by the width of e.g. the first or second spacer.

In one embodiment, the fourth feature may be formed using the third and fourth spacers as guides. In addition to the advantages described above, using the third and fourth spacers may also help to guarantee a well defined width of the fourth feature, a width defined by the separation between the third and fourth spacers. If the third and fourth spacers have equal or approximately equal width, the fourth feature may be symmetrically formed between the second and third features. This is also true if the fourth feature is formed such that it overlaps parts of both the third and fourth spacers. If the fourth feature is formed such that it overlaps only one of the third and fourth spacers, a minimum distance to the features is still guaranteed (defined by the widths of the third and fourth spacers).

In one embodiment, each one of the first, second, third and fourth features may be formed as a respective elongated feature. The first, second, third and fourth features may extend (substantially) in parallel in relation to each other. The first, second, third and fourth features may preferably be formed as line-shaped features. The features may for instance be used to form a group of interconnects between different points on e.g. a chip (e.g. as part of a back-end-of-line layer, BEOL).

It is appreciated that other embodiments using all possible combinations of features recited in the above described embodiments may be envisaged.

### Brief description of drawings

The above, as well as additional objects, features and advantages of the present inventive concept, will be better understood through the following illustrative and non-limiting detailed description of preferred embodiments of the present inventive concept. Reference is made to the appended drawings, in which

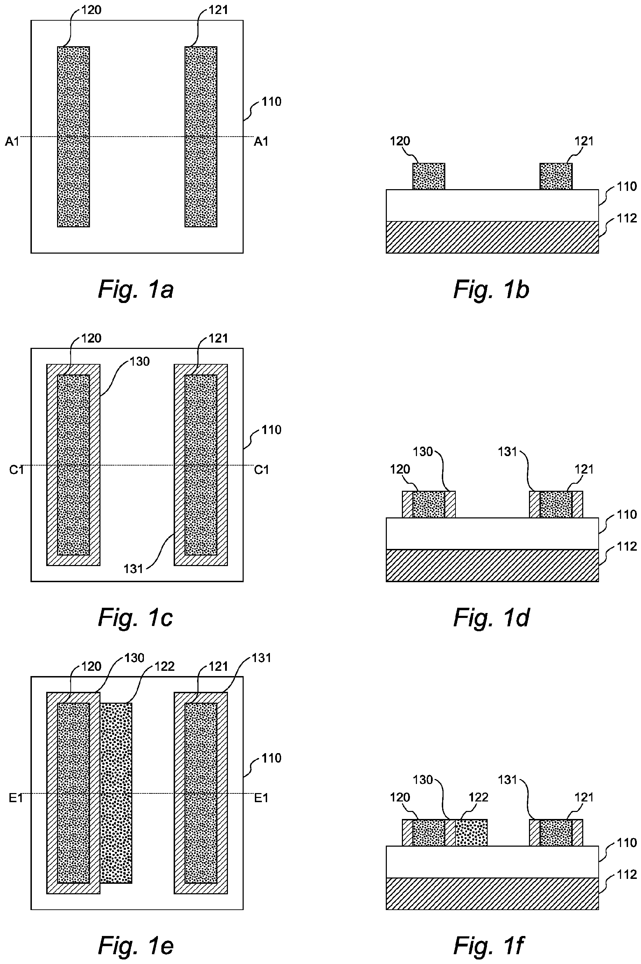

Figs 1a-1l schematically illustrates a method for patterning a target layer according to one or more embodiments of the present inventive concept. As illustrated in the figures, the sizes of the elements, features and other structures may be exaggerated or not depicted proportionally for illustrative purposes. Thus, the figures are provided to illustrate the general elements of the embodiments.

In the drawings, like reference numerals will be used for like elements unless stated otherwise.

### Detailed description

A method of patterning a target material layer will now be described with reference to Figs 1a-1l.

In Fig. 1a, a top-view of a target material layer 110 that is to be patterned is shown. To form a pattern in the target material layer 110, one or many features may be formed over the layer and used as mask portions. As an example of a process for such a formation, a feature material layer may first be formed over the target material layer 110 and a photoresist may then be applied over the feature material layer. Using a mask, or sub-mask, selected portions of the photoresist may be exposed and then developed to determine what portions of the feature material layer that are to be removed or kept during a subsequent etching process. The remaining features may serve as masking portions during another subsequent etching step, such that the features may be transferred to the target material layer 110. Although in the following, reference will be made to the features 120, 121, 122, 123 it should be noted that the target material layer 110 shown in the figures may represent only a portion of the target material layer 110 over which multiple sets of features such as 120, 121, 122, 123 (or of features similar to the features 120, 121, 122, 123) are formed.

In the figure, a first feature 120 and a second feature 121 have been formed according to a desired layout. Preferably, the features 120 and 121 are formed during a single photolithographic step (i.e. using a first sub-mask) and subsequent etching process. The first feature 120 and the second feature 121 may be formed by depositing a feature material layer over the target material layer 110 and subsequently patterning the feature material layer to form the first and the second feature 120, 121. To enable the patterning, a photoresist may be applied over the feature material layer. Using the first sub-mask, selected portions of the photoresist may be exposed and then developed to determine what portions of the feature material layer that are to be removed or kept during a subsequent etching process resulting in the formation of the first and the second feature 120, 121. However, it is also envisaged that the features 120 and 121 may be formed during different steps if necessary.

Preferably, a separation between the first feature 120 and the second feature 121 is equal to, or larger but not substantially larger than, that of a CDU obtainable by the photolithographic process used to form the features. In the figure, the features 120 and 121 are shown having the same width. It is also envisaged that different features, such as features 120 and 121, may be formed such that their widths are different. The width may be controlled depending on e.g. the photolithographic process, and e.g. on the masks or sub-masks used when forming the features.

Fig. 1b shows a side-view of the structure in Fig. 1a when viewed perpendicular to the cut A1-A1. In Fig. 1b, the target material layer 110 is shown layered on top of a second layer 112 described in more detail below.

In Fig. 1c, a top-view of the target material layer 110 is shown. Here, a first spacer 130 (which interchangeably may be referred to as a first spacer portion 130) has been formed on the sidewalls of the first feature 120, and a second spacer 131 (which interchangeably may be referred to as a second spacer portion 131) has been formed on the sidewalls of the second feature 121. In the figure, the spacers 130 and 131 are shown to be formed on all sidewalls of the features 120 and 121 respectively. It is, however, also envisaged that the spacers 130 and 131 may be formed only on one or more of the sidewalls of the features 120 and 121 respectively. Preferably, the first spacer 130 is formed at least on one sidewall of the first feature 120 that faces the second feature 121. Similarly, the second spacer 131 is formed at least on one sidewall of the second feature 121 that faces the first feature 120. The spacers 130 and 131 may be formed e.g. by first depositing spacer material followed by subsequent etching. The spacer material may be deposited (from above) as a conformal spacer material layer such that it covers both the features 120 and 121 and a surrounding (horizontal) area of the target material layer 110 that is not covered by the features 120 and 121. In a subsequent etching step, parts of the deposited spacer material may be removed such that spacer material is only left on the sidewalls of the features 120 and 121. In addition, a chemical-mechanical planarization (CMP) process may be used to remove any (remaining) spacer material e.g. on top of the features 120 and 121, such that the top surfaces of the features 120 and 121 are not covered by any spacer material. In Fig. 1c, it is assumed that such a process of etching (and possibly also CMP) has already been performed, and the spacers 130 and 131 are shown only on the vertical sidewalls of the features 120 and 121. By the deposition and etching process used when forming the spacers 130 and 131, the thickness or width of the spacers 130 and 131 may be controlled. In Fig. 1c, the width of the spacers 130 and 131 are shown to be less than that of the features 120 and 121. It is, however, also envisaged that the width of the spacers 130 and 131 are equal to or even larger than that of the features 120 and 121. In the figure, the width of the spacers 130 and 131 are also shown to be equal on all sides of the features 120 and 121, and also equal for both spacers 130 and 131. It is envisaged that the width of the spacers, such as spacers 120 and 121, may be varied such that the width is different on different sidewalls of features, such as features 120 and 121, and also different for different spacers.

Fig. 1d shows a side-view of the structure in Fig. 1c when viewed perpendicular to the cut C1-C1. In the figure, the cross-sections of the spacers 130 and 131 are shown as rectangular. It is also envisaged that the cross-sections may be less ideal, e.g. with rounded or slanted corners, due to e.g. non-ideal outcomes of the processes involved when forming spacers.

In Fig. 1e, a top-view of the target material layer 110 also shows a third feature 122 that has been formed over the target material 110, between the first feature 110 and the second feature 120. The third feature 122 may be formed using e.g. a photolithographic process similar or equal to the one used when forming the features 120 and 121. A feature material layer and photoresist layer may be deposited on top of the structure shown in Figs 1c and 1d, and a mask or (second) sub-mask may be used to selectively expose parts of the photoresist corresponding to the wanted third feature 122. After etching the feature material layer, the third feature 122 will remain and be formed over the target material 110. When forming the third feature 122 using a method as described above, positioning of the mask or sub-mask used may affect the positioning of the third feature 122, especially in a direction defining the separation of the features 120, 121 and 122 (i.e. their main direction of separation). When forming the third feature 122 between the first feature 120 and the second feature 121, at least one of the first spacer 130 and the second spacer 131 may be used as a guide. If, for example, the mask or sub-mask used to form the third feature 122 happened to be positioned too close to e.g. the first feature 120, the first spacer 130 will make sure that the separation between the first feature 120 and the third feature 122 is not affected by such a mask or sub-mask misalignment. It is envisaged that any material of the third feature 123 that ends up on top of the first spacer 130 may be removed at a later stage, for example using CMP or any other suitable process. When forming the third feature 122, it is also possible that no misalignment of the used mask or sub-mask is present, or that the third feature 122 is formed such that the separation to the first feature 120 is greater than the width of the first spacer 130. In both of these situations, the first spacer 130 does not affect the formation of the third feature 122.

Fig. 1f shows a side-view of the structure in Fig. 1e when viewed perpendicular to the cut E1-E1. In the figure, the third feature 122 is shown as being formed adjacent to the first spacer 130. This may be the result of no misalignment when positioning the mask or sub-mask used in the formation of the third feature 122, or a result of a misalignment causing the third feature 122 to partly overlap the first spacer 130. In the case of the latter, an additional step of removing the overlapping part is envisaged to already have taken place (not shown).

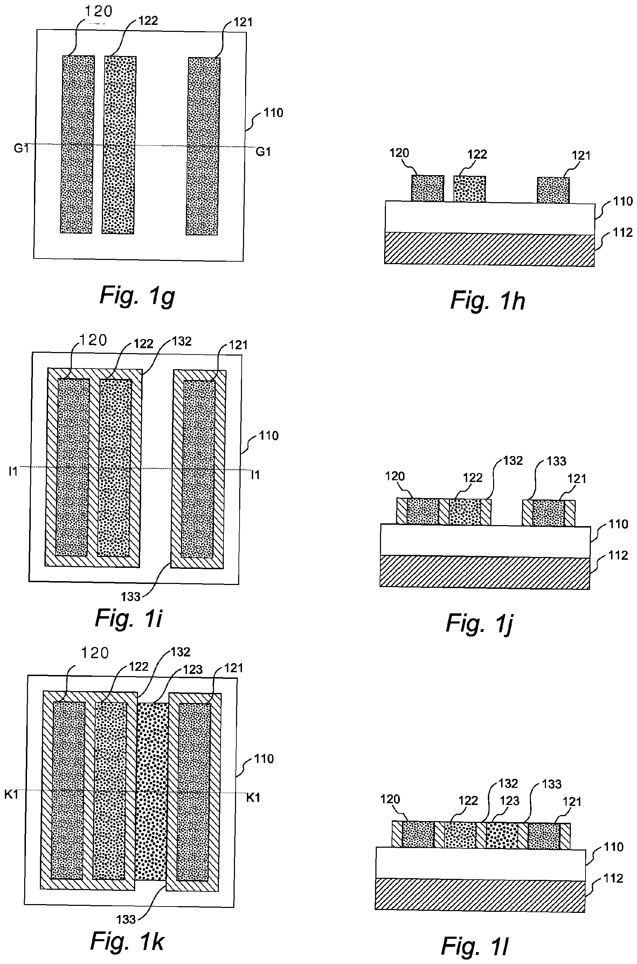

In Fig. 1g, the first spacer 130 and the second spacer 131 has been removed, e.g. by a selective chemical etching process, leaving a separation between the first feature 120 and the third feature 122. According to the method, the removal of the first spacer 130 and the second spacer 131 allows for subsequent features and spacers to be properly aligned.

Fig. 1h shows a side-view of the structure of Fig. 1g when viewed perpendicular to the cut G1-G1.

In Fig. 1i, a third spacer 132 has been formed on the sidewalls of the first feature 120 and the third feature 122, and a fourth spacer 133 has been formed on the sidewalls of the second feature 121. In the figure, the spacers 132 and 133 are shown to be formed on all sidewalls of the features 120 and 122, and 121, respectively. It is, however, also envisaged that the spacers 132 and 133 may be formed only on one or more of the sidewalls of the features 120 and 122, and 121, respectively. Preferably, the third spacer 132 (which interchangeably may be referred to as a third spacer portion 132) is formed at least on one sidewall of the third feature 122 that faces the second feature 121. Similarly, the fourth spacer 133 (which interchangeably may be referred to as a fourth spacer portion 133) is formed at least on one sidewall of the second feature 121 that faces the third feature 122. The spacers 132 and 133 may be formed using methods similar to those described earlier: by first depositing spacer material (from above) as a conformal spacer material layer such that it covers the features 120, 121 and 122 and a surrounding (horizontal) area of the target material layer 110 that is not covered by the features 120, 121 and 122; and, in a subsequent etching step, removing parts of the deposited spacer material such that spacer material is only left on the sidewalls of the features 120, 121 and 122. Preferably, both of spacers 132 and 133 are formed during the same step, but it is also envisaged that the spacers may be formed during separate steps if necessary. The third spacer 132 and the fourth spacer 133 is formed such that they leave a gap between them, a gap in which another feature may be formed at a subsequent step. As the inventors have realized, the size of the gap is dependent not only on the widths of the spacers 132 and 133 (which may be varied dependent on the process of formation of the spacers), but also on the fact that the first spacer 130 and the second spacer 131 were removed before the spacers 132 and 133 were formed. If, for example, the second spacer 131 was still present when the fourth spacer 133 was formed, the second feature 121 would have not only one but two spacers formed on one of its sidewalls. As a consequence, it is likely that the combined width of these two spacers would be larger than that of a single spacer, and that the gap formed between the third feature 122 and the second feature 121 would be too narrow.

Fig. 1j shows a side-view of the structure of Fig. 1i when viewed perpendicular to the cut l1-l1. As mentioned earlier, the formed spacers 132 and 133 may be rectangular as in the figure, or of less ideal shape due to imperfections of the methods used for their formation.

In Fig. 1k, a fourth feature 123 has been formed in the gap between the third spacer 132 and the fourth spacer 133 (i.e. between the third feature 122 and the second feature 121). The fourth feature 123 may be formed by depositing a feature material layer over the target material layer 110 and subsequently patterning the feature material layer to form the fourth feature 123. To enable the patterning, a photoresist may be applied over the feature material layer. Using a mask, or (third) sub-mask, selected portions of the photoresist may be exposed and then developed to determine what portions of the feature material layer that are to be removed or kept during a subsequent etching process resulting in the formation of the fourth feature 123.

When forming the fourth feature 123, the third spacer 132 and the fourth spacer 133 may be used as guides. If, for example, the mask or sub-mask used to form the fourth feature 123 happened to be positioned too close to e.g. the third feature 122, the third spacer 132 will make sure that the separation between the third feature 122 and the fourth feature 123 is not affected by such a mask or sub-mask misalignment. Likewise, the fourth spacer 133 will make sure that also the separation between the fourth feature 123 and the second feature 121 is not affected by misalignment. It is envisaged that any material of the fourth feature 123 that ends up on top of the third spacer 132 and/or the fourth spacer 133 may be removed at a later stage, for example using CMP or any other suitable process (not shown). Thus the spacers 132 and 133 will make sure that the distances between the fourth feature 123 and the features 121 and 123 are kept as required. When forming the fourth feature 123, it is possible that no misalignment of the used mask or sub-mask is present. In the figure, the fourth feature is shown being adjacent, and in contact, with both the third feature 122 and the second feature 121. It is also possible that the fourth feature 123 is formed without misalignment but such that its width is less than the gap formed between the spacers 132 and 133, leaving a gap between the fourth feature 123 and one or both of the spacers 132 and 133. By removing the first spacer 130 and the second spacer 131 earlier, the size of the gap between the spacers 132 and 133 may be well controlled and large enough such that the proper width of the fourth feature 123 may fit therein.

Fig. 1l shows a side-view of the structure of Fig. 1k when viewed perpendicular to the cut K1-K1.

After the features 120, 121, 122 and 123 have been formed, the target material layer 110 may be patterned using the third feature 122 and the fourth feature 123, and at least one of the first feature 120 and the second feature 121, as mask portions. Preferably, the third spacer 132 and the fourth spacer 133 are removed before the patterning. Since the separation of the first feature 120 and the second feature 121 is preferably on the order of the CDU, the formation also of the third feature 122 and the fourth feature 133 in between features 120 and 121 renders a pattern of features whose individual separation may be less than that of the CDU. For the feature layout shown in Fig. 1l, the density of features within a distance of a CDU is three times as high as it would be if all features were to be formed during a single photolithographic step, using a single mask.

All features (e.g. features 120, 121, 122 and 123) may be formed of a same feature material. It is, however, also envisaged that different feature materials may be used and that the resulting features may be of different suitable materials. Suitable feature materials may include silicon oxide (e.g. SiO₂), silicon nitride (e.g. Si₃N₄), amorphous carbon (a-C), or amorphous silicon (a-Si). Combinations of these materials are also envisaged.

All spacers (e.g. spacers 130, 131, 132 and 133) are preferably formed of a same spacer material. It is, however, also envisaged that different spacer materials may be used and that the resulting spacers may be of different suitable materials. Suitable spacer materials may include SiO₂, Si₃N₄, a-C, a-Si or titanium oxide (e.g. TiO). Preferably, the spacer material(s) is/are selected to be different from the feature materials such the spacer material(s) may be selectively removed from the respective features by etching.

Generally, the target material layer 110 may be formed by any material that should be patterned. The target material layer 110 may also be not just a single material but include a composition of different materials. For instance, a target material may be a metal such as Cu, Al, Tn, Ag, Ni, or Au (or other conductor materials) or a semiconductor such as a group IV semiconductor (e.g. Si or Ge) or a group III-V semiconductor (e.g. GaN, GaP or GaAs) to provide a few non-limiting examples. Other possible target materials include SiO₂, Si₃N₄, a-C, a-Si or TiO. If any of these latter types of target materials is used the target material is preferably selected to be different from the feature material(s) and spacer material(s) to allow the feature material(s) and the spacer material(s) to be selectively removed from the target material layer 110 by etching..

The second layer 112 may represent any other layer on which the target material layer 110 may be deposited (or otherwise provided), and patterned according to a desired layout. The second layer 112 may be a substrate, and be of a material including e.g. silicon oxide (e.g. SiO₂), silicon nitride (e.g. Si₃N₄), silicon carbide (SiC), amorphous carbon (a-C), amorphous silicon (a-Si), or titanium nitride (TiN).The second layer 112 may also itself be patterned using the patterned target material layer 110 wherein the patterned target material layer 110 may be used as a hard mask. The second layer 112 may also be a transistor structure, a BEOL layer, a silicon structure, a storage layer or others.

The removal of the first spacer 130 and the second spacer 131 before the formation of the third spacer 132 and the fourth spacer 133 allows for an accurate pattern of features with wanted dimensions and individual separations to be formed. As an example, if the object is to form a pattern of features of equal width, separated by an equal distance of separation, the illustrated method allows for such a pattern to be formed, and transferred to the target material layer 110. The first two features (corresponding to features 120 and 121 in the above described embodiment) would be formed separated by a distance corresponding to the CDU. Then, first and second spacers (corresponding to spacers 130 and 131) would be formed, such that the width of the spacers corresponds to the wanted distance of separation. Next, the third feature (corresponding to feature 122) would be formed using e.g. the first spacer as a guide, such that the separation between the first and third feature is at least (and preferably equal to) the width of the first spacer. After forming the third feature, the first and second spacers would be removed, leaving only the first, second and third features over the target material layer, each having equal widths and a wanted separation between the first and third feature. Next, third and fourth spacers (corresponding to spacers 132 and 133) would be formed, where the width of the spacers are equal to the previous, now removed, spacers. Finally, a fourth feature (corresponding to feature 123) would be formed in between the third and second feature, using the third and fourth spacers as guides such that the separation between the fourth feature and the third and second features are at least (and preferably equal to) the widths of the third and fourth spacers. If all remaining spacers are removed, the first, second, third and fourth features would remain over the target material layer, each having a wanted width and a wanted individual separation as a result of using the method. This enables formation of the features with a more dense spacing than possible if only a single photolithographic step (using a single mask or sub-mask) were to be used and with the fourth feature formed symmetrically between the second and the third features.

In the above, the inventive concept has mainly been described with reference to a limited number of examples. However, as is readily appreciated by a person skilled in the art, other examples than the ones disclosed above are equally possible within the scope of the inventive concept, as defined by the appended claims. Variations to the disclosed embodiments may be understood and effected by the skilled person in practicing the inventive concept, from a study of the drawings, the disclosure and the appended claims.

As an example, the first feature 120 and the second feature 121 are in the above preferably illustrated as being of the same material. However, the scope of the inventive concept as defined by the appended claims also covers a situation where e.g. the first feature 120 and the second feature 121 are made from different materials, even though additional processing steps may be necessary. Additionally, in some applications the second layer 112 need not be present and the target material layer 110 may represent the final layer that is to be patterned.

In the claims, the word "comprising" does not exclude other steps or elements, and the indefinite article "a" or "an" does not exclude a plurality. Likewise, the mere fact that certain steps and/or features are recited in mutually different dependent claims does not indicate that a combination of these features cannot be used to advantage.

## Claims

1. A method of patterning a target material layer (110), the method comprising:
forming a first feature (120) and a second feature (121) over the target material layer (110);
forming a first spacer (130) on at least a sidewall of the first feature (120) facing the second feature (121), and forming a second spacer (131) on at least a sidewall of the second feature (121) facing the first feature (120);
forming a third feature (122) over the target material layer (110) between the first and second features (120, 121);
removing the first and second spacers (130, 131);
forming, after removing the first and second spacers (130, 131), a third spacer (132) on at least a sidewall of the third feature (122) facing the second feature (121), and forming a fourth spacer (133) on at least a sidewall of the second feature (121) facing the third feature (122);
forming a fourth feature (123) over the target material layer (110) between the second and third features (121, 122); and
patterning the target material layer (110) using the third and fourth features (122, 123), and at least one of the first and second features (120, 121), as mask portions.

2. The method of claim 1, further comprising removing the third and fourth spacers (132, 133) after forming the fourth feature (123) and before pattering the target material layer (110).

3. The method of claim 1 or 2, wherein the first and the second features (120, 121) are formed using a same sub-mask.

4. The method of any one of the preceding claims, wherein the first and the second spacers (130, 131) are formed during a same process.

5. The method of any one of the preceding claims, wherein the third feature (122) is formed using at least one of the first and second spacers (130, 131) as a guide.

6. The method of any one of the preceding claims, wherein the fourth feature (123) is formed using the third and fourth spacers (132, 133) as guides.

7. The method of any one of the preceding claims, wherein each one of the first, second, third and fourth features (120, 121, 122, 123) are formed as a respective elongated feature.

8. The method of any one of the preceding claims, wherein the first, second, third and fourth features (120, 121, 122, 123) are formed to extend in parallel to each other.

## Patentansprüche

1. Verfahren zur Strukturierung einer Zielmaterialschicht (110), das Verfahren umfassend:
Bilden einer ersten Struktur (120) und einer zweiten Struktur (121) auf einer Zielmaterialschicht (110);
Bilden eines ersten Abstandshalters (130) an mindestens einer Seitenwand der ersten Struktur (120), die der zweiten Struktur (121) zugewandt ist, und Bilden eines zweiten Abstandshalters (131) an mindestens einer Seitenwand der zweiten Struktur (121), die der ersten Struktur (120) zugewandt ist;
Bilden einer dritten Struktur (122) über der Zielmaterialschicht (110) zwischen der ersten und der zweiten Struktur (120, 121);
Entfernen des ersten und zweiten Abstandshalters (130, 131); Bilden, nach dem Entfernen des ersten und zweiten Abstandshalters (130, 131), eines dritten Abstandshalters (132) an mindestens einer Seitenwand der dritten Struktur (122), die der zweiten Struktur (121) zugewandt ist, und Bilden eines vierten Abstandshalters (133) an mindestens einer Seitenwand der zweiten Struktur (121), die der dritten Struktur (122) zugewandt ist;
Bilden einer vierten Struktur (123) über der Zielmaterialschicht (110) zwischen der zweiten und dritten Struktur (121, 122); und
Strukturieren der Zielmaterialschicht (110) unter Verwendung der dritten und vierten Struktur (122, 123) und mindestens einer der ersten und zweiten Strukturen (120, 121) als Maskenabschnitte.

2. Verfahren nach Anspruch 1, ferner umfassend das Entfernen des dritten und vierten Abstandshalters (132, 133) nach dem Bilden der vierten Struktur (123) und vor dem Strukturieren der Zielmaterialschicht (110).

3. Verfahren nach Anspruch 1 oder 2, wobei die erste und die zweite Struktur (120, 121) unter Verwendung derselben Untermaske gebildet werden.

4. Verfahren nach einem der vorhergehenden Ansprüche, wobei der erste und der zweite Abstandshalter (130, 131) während eines gleichen Prozesses gebildet werden.

5. Verfahren nach einem der vorhergehenden Ansprüche, wobei die dritte Struktur (122) unter Verwendung mindestens eines der ersten und zweiten Abstandshalter (130, 131) als eine Führung gebildet wird.

6. Verfahren nach einem der vorhergehenden Ansprüche, wobei die vierte Struktur (123) unter Verwendung des dritten und vierten Abstandshalters (132, 133) als Führungen gebildet wird.

7. Verfahren nach einem der vorhergehenden Ansprüche, wobei jede der ersten, zweiten, dritten und vierten Strukturen (120, 121, 122, 123) als eine jeweilige längliche Struktur gebildet werden.

8. Verfahren nach einem der vorhergehenden Ansprüche, wobei die erste, zweite, dritte und vierte Struktur (120, 121, 122, 123) gebildet werden, um parallel zueinander zu verlaufen.

## Revendications

1. Procédé pour la formation de motifs sur une couche de matériau cible (110), le procédé comprenant :
la formation d'un premier élément (120) et d'un deuxième élément (121) sur la couche de matériau cible (110) ;
la formation d'un premier espaceur (130) sur au moins une paroi latérale du premier élément (120) tournée vers le deuxième élément (121), et la formation d'un deuxième espaceur (131) sur au moins une paroi latérale du deuxième élément (121) tournée vers le premier élément (120) ;
la formation d'un troisième élément (122) sur la couche de matériau cible (110), entre les premier et deuxième éléments (120, 121);
le retrait des premier et deuxième espaceurs (130, 131) ;
la formation, après le retrait des premier et deuxième espaceurs (130, 131), d'un troisième espaceur (132) sur au moins une paroi latérale du troisième élément (122) tournée vers le deuxième élément (121), et la formation d'un quatrième espaceur (133) sur au moins une paroi latérale du deuxième élément (121) tournée vers le troisième élément (122) ;
la formation d'un quatrième élément (123) sur la couche de matériau cible (110), entre les deuxième et troisième éléments (121, 122) ; et
la formation de motifs sur la couche de matériau cible (110) à l'aide des troisième et quatrième éléments (122, 123), et de l'un au moins parmi les premier et deuxième éléments (120, 121), comme parties de masque.

2. Procédé selon la revendication 1, comprenant en outre le retrait des troisième et quatrième espaceurs (132, 133) après la formation du quatrième élément (123) et avant la formation de motifs sur la couche de matériau cible (110).

3. Procédé selon la revendication 1 ou 2, dans lequel les premier et deuxième éléments (120, 121) sont formés à l'aide d'un même sous-masque.

4. Procédé selon l'une quelconque des revendications précédentes, dans lequel les premier et deuxième espaceurs (130, 131) sont formés au cours d'un même processus.

5. Procédé selon l'une quelconque des revendications précédentes, dans lequel le troisième élément (122) est formé à l'aide de l'un au moins parmi les premier et deuxième espaceurs (130, 131) comme guide.

6. Procédé selon l'une quelconque des revendications précédentes, dans lequel le quatrième élément (123) est formé à l'aide des troisième et quatrième espaceurs (132, 133) comme guides.

7. Procédé selon l'une quelconque des revendications précédentes, dans lequel chacun parmi les premier, deuxième, troisième et quatrième éléments (120, 121, 122, 123) est formé comme un élément allongé respectif.

8. Procédé selon l'une quelconque des revendications précédentes, dans lequel les premier, deuxième, troisième et quatrième éléments (120, 121, 122, 123) sont formés pour s'étendre parallèlement les uns aux autres.
